Europäisches Patentamt

European Patent Office

Office européen des brevets

(11) Publication number: **0 155 942**
**B1**

(12) # EUROPEAN PATENT SPECIFICATION

(45) Date of publication of patent specification: **18.10.89**

(51) Int. Cl.⁴: **G 03 B 27/62**

(21) Application number: **84902868.3**

(22) Date of filing: **02.07.84**

(86) International application number:
**PCT/US84/01060**

(87) International publication number:
**WO 85/01126 14.03.85 Gazette 85/07**

(54) **METHOD OF PRODUCING CONTAMINATION-FREE PELLICLES.**

(30) Priority: **29.08.83 US 527251**

(43) Date of publication of application:
**02.10.85 Bulletin 85/40**

(45) Publication of the grant of the patent:
**18.10.89 Bulletin 89/42**

(84) Designated Contracting States:
**AT BE CH DE FR GB LI LU NL SE**

(56) References cited:
**JP-A-55 049 254**
**US-A-3 848 596**
**US-A-3 911 937**
**US-A-3 970 362**
**US-A-4 131 363**
**US-A-4 252 846**
**US-A-4 343 964**

**IBM TECHNICAL DISCLOSURE BULLETIN, vol.
20, no. 6, November 1977, page 2207, New
York, US; R.W. MARTIN et al.: "Glass mask
protection and particulate cleaning"**

(73) Proprietor: **YEN, Yung-Tsai**
**1192 St. Anthony Court**
**Los Altos, CA 94022 (US)**

(72) Inventor: **YEN, Yung-Tsai**
**1192 St. Anthony Court**
**Los Altos, CA 94022 (US)**

(74) Representative: **Enskat, Michael Antony Frank
et al**
**Michael A. Enskat & Co. 9, Rickmansworth Road
Watford Hertfordshire WD1 7HE (GB)**

Courier Press, Leamington Spa, England.

## Description

### TECHNICAL FIELD

The present invention relates generally to protecting surfaces from dust or other contamination and more specifically to methods for preventing contamination to the interior surface of the transparent film portion of a pellicle. The predominant current usage of the present invention relates to prevention of contamination, during shipment and storage, of the interior film surfaces of pellicles used in the semiconductor industry.

### BACKGROUND ART

Integrated circuits and other elements in the semiconductor industry are manufactured using photoillumination techniques incorporating devices known as photomasks. Photomasks are transparent sheets of material having an opaque pattern deposited or otherwise placed on one surface. The pattern presents an optical blockage of electromagnetic radiation which activates photoresist chemicals on the surface of the material onto which the circuit design is to be placed.

The manufacture of integrated circuits requires very precise techniques. Accordingly, very tight tolerances are necessary in the production and use of photomasks. For example, any dust adhering to the surface of the photomask may interfere with the radiation path and cause the production of a defective circuit element. Therefore, it is very important to protect the photomask surface from dust and other contamination.

One common method utilized for photomask protection is a device known as a pellicle. A pellicle includes a thin transparent film or membrane of material which is bonded to the surface of the photomask via a support element such that a gap exists between the surface of the photomask and the film. A sealed volume is created between the surfaces. The film surface protects the photomask surface from contamination. The separation between the film and the photomask permits the surface of the film to be out of focus with respect to the surface of the mask during photoillumination. Therefore, dust which adheres to the surface of the film will not be in focus with respect to the mask and will have a significantly lessened effect on the circuit resulting from illumination of the mask.

The construction and use of the pellicles is particularly described in United States Patent No. 4,131,363, issued to V. Shea. et al. The Shea, et al patent discloses the use and manufacture of pellicles similar to those in current use in the industry.

A typical pellicle includes a spacer and support element generally in the form of a ring having a discrete thickness. A film is stretched across the ring and bonded to one edge about the entire circumference while the other edge of the support ring is adhered to the surface of the photomask.

Increasing use and popularity of pellicles, combined with continually increasing demands for precision, have led to situations wherein pellicle application alone is insufficient contamination protection to meet industry standards. Dust contamination of the pellicle film itself may be sufficient to cause imperfections in the final product. Therefore, it has become important not only to protect the surface of the photomask from contamination, but to also protect the surfaces of the pellicle film from contamination. The present invention relates to a novel and significantly improved method of preventing contamination of the interior surface of the pellicle film, as compared with prior art methods.

Typically, the prior art method of cleaning the surface of a pellicle film has involved the use of an air or gas jet. Compressed gaseous material is blown across the surface of the film in order to dislodge any dust or other material that may have become adhered to that surface. This method has been reasonably successful with regard to the exterior surface of the film. However, the interior surface of the film is surrounded by the ridge provided by the support ring. The ridge provides an aerodynamic barrier which causes turbulence and prevents effective cleaning of the interior film surface once it has been bonded to the support ring. Therefore, it is extremely important to prevent any dust or contamination from becoming adhered to the interior surface of the pellicle film at any time after it has been bonded to the support ring.

None of the prior art methods have been successful in providing a clean and uncontaminated inner surface of the pellicle such that it is completely uncontaminated at the time that the pellicle is installed upon the photomask. An effective method of protecting the pellicle during, storage, shipment and manipulation is greatly desired in the industry.

Accordingly, it is an object of the present invention to provide an improved method for packaging and sealing pellicles.

It is another object of the present invention to provide an improved pellicle.

According to the present invention there is provided a method of manufacture of a contamination-protected pellicle including a closed loop support member defining an aperture, characterised by the steps of selecting a planar cover sheet, applying a layer of contact adhesive to one surface of the cover sheet, and detachably installing the cover sheet upon an axial edge of the support member of a pellicle so as to close the aperture and form, with the pellicle, an enclosed volume, the orientation of the cover sheet being such that the layer of contact adhesive is within said volume.

According to the present invention there is further provided a method of manufacture of a contamination-protected pellicle, comprising a pellicle film to be mounted upon a closed loop support member, characterised by the steps of selecting a planar cover sheet, applying a layer of contact adhesive to one surface of the cover sheet, detachably installing the cover sheet upon an axial end face of the support member, and thereafter installing the pellicle film upon the opposite axial end face of the support member to form an enclosed volume within which the layer of contact adhesive is provided.

According to the present invention there is further provided a pellicle in which the interior film surface is protected from particulate contamination, comprising a closed loop support member and a planar transparent film stretched across said support member and bonded thereto along one axial face thereof, characterised by a cover sheet, detachably bonded to the other axial face of said support member so as to form a sealed interior volume therewith, the interior facing surface of the cover sheet being provided with a layer of contact adhesive.

With the pellicles hereinafter described the sealed volume provided by the cover prevents intrusion of particulate contamination during storage and transfer. The adhesive protective cover substantially eliminates particulate contamination of the interior surface of the pellicle film. When the cover is applied to the installation of the pellicle film on the support ring, the pellicle film is installed in a pristine condition and maintained in such condition until use. The pellicle uses relatively inexpensive and readily available materials and enables the cover sheet to be removed at the very last moment before installation of the pellicle on the photomask without danger of contamination from the cover sheet. The protective cover permits inspection and testing of the pellicle film without the necessity of removal of the cover.

A method of manufacturing a contamination protected pellicle and the pellicle itself, both embodying the invention, will now be described by way of example, with reference to the accompanying diagrammatic drawings in which:

Fig. 1 is a bottom perspective view of a protected pellicle according to the method of the present invention; and

Fig. 2 is an inverted cross sectional view, taken along line 2-2, of the protected pellicle of Fig. 1.

The method of protecting the interior surface of pellicle films from particulate contamination is utilized in the integrated and semiconductor manufacturing industries in order to ensure clean and uncontaminated pellicles for use with photomasks. The method produces pellicles which are protected from contamination.

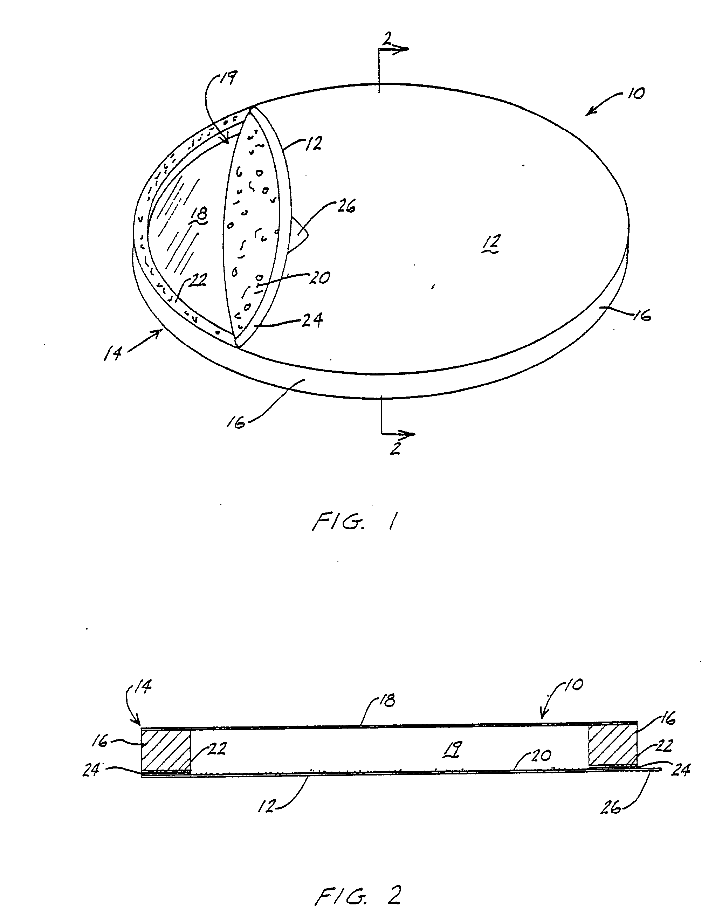

The pellicle 10, as shown in Figure 1, includes a protective cover 12 formed according to the method of the present invention and installed upon a conventional pellicle 14.

The pellicle 14 includes a circular support ring 16 having a transparent pellicle film or membrane 18 adhered to the entire circumference one axial edge thereof such that the film 18 extends across the entire aperture in the support ring 16 and seals the aperture completely.

The protective cover 12 is bonded to the axial surface of the support ring 16 opposite the pellicle film 18. The cover extends across the entire aperture in the support ring 16 such that, together with the support ring 16 and the pellicle film 18, it forms a sealed interior volume 19. The primary purpose of the invention is to maintain the interior volume 19 and the interior surface of the pellicle film 18 free of particulate contamination.

The support member 16 illustrated is in the form of a circular ring. While this is the most common form of pellicle support member other shapes are also utilized. Any planar closed loop support member is adaptable to the method of the present invention.

As is also shown in Fig. 1, the interior surface of a preferred embodiment of the protective cover 12 is provided with a continuous layer of contact adhesive 20. The contact adhesive 20 operates to capture and retain particulate matter that comes into contact with it. Thus, any matter which is trapped in the interior volume 19 and which moves in any way within the volume 19 is likely to impact the contact adhesive 20 and remain adhered thereto. Agitation of the entire protected pellicle 10 may help dislodge particles which are adhered to the film surface and cause them to flow within the interior volume 19 until they are captured by the contact adhesive 20. This may improve the contamination protection properties of the method.

The edge of the support ring 16 which engages the protective cover 12 is also provided with a layer of powerful contact adhesive 22. The purpose of the adhesive 22 on the support ring 16 is predominantly to bond the pellicle 14 to the surface of the photomask. The powerful adhesive 22 is ordinarily too sticky to be amenable to ready removal of the cover 12. Therefore, the preferred embodiment 10 employs a spacer ring 24 which is selected to be more easily peeled from the powerful adhesive 22. Another possible method is for the contact adhesive 20 and the powerful adhesive 22 to be the same and to provide a ring of releasing agent on the cover 12 so that it will readily peel off the ring 16 when desired.

In the preferred embodiment, the protective cover 12 is provided with a grasping extension 26 along one portion of the edge thereof, such that it may be easily removed from the pellicle 14 when such removal is desired. Although it is not required, the remainder of the protective cover 12 is ordinarily trimmed about the circumference of the support ring 16 for easy handling and storage. Thus the only protrusion is the grasping extension 26 placed at a preselected location.

Fig. 2 illustrates the protected pellicle 10 in a cross sectional view, taken along line 2-2 of Fig. 1 and inverted therefrom. In Fig. 2. which is not in proportion with respect to Fig. 1, the relative axial spacing of the elements is illustrated.

The illustration of Fig. 2 shows that the exterior surface of pellicle film 18 provides an unobstructed planar surface. This surface is entirely appropriate for cleaning by application of a gas jet across the surface to sweep any debris from the film 18. However, as is shown in Fig. 2, the interior surface of the film 18, although equally planar, is obstructed at the edges by the support ring 16. Thus the interior volume 19 is subject to turbulence and is inappropriate for precise cleaning of the film surface 18 by gas jet means. Thus it is ordinarily not efficacious to remove particulate matter from the interior surface of the film 18 at the time of application or use.

The method of providing the protected pellicle 10 illustrated in the drawing includes a series of steps. These steps include the selection of an appropriate material for the planar cover sheet, the application of a layer of contact adhesive to one surface of the cover sheet, the placement of a spacer ring 24, the detachable installation of the adhesive protective cover to one surface of the support ring of the pellicle, and optionally, trimming the cover sheet to conform with the lateral dimensions of the support ring.

The selection of the planar cover sheet material takes into account various necessary properties. Initially, the cover sheet must be uniformly planar on its interior surface for appropriate results. Furthermore, it must be pliable such that it is easily installed upon and detached from the support ring. Additionally, the cover sheet material must be selected to have minimal light reflection characteristics such that it does not interfere with the electromagnetic radiation inspection techniques utilized to test the pellicle film for impurities and defects. Finally, to obtain the greatest economic benefit, the most readily available and inexpensive material should be selected.

The properties regarding transmittal and reflection of electromagnetic radiation are particularly important for the cover sheet material. This is true because one of the primary opportunities for particulate contamination to become attached to the inside of the pellicle film under prior art processes is during the inspection period. Therefore it is highly desirable to undertake the film inspection while the protective cover remains in place. Therefore, the protective cover must not in any way interfere with the inspection. A flat black material appears to be the most successful.

The preferred embodiment of the protected pellicle according to the method of the present invention utilizes polyester printed to present a black interior surface and covered with a doublesided transfer tape as a cover sheet material. Other possible materials include transparent mylar adhesive tape and 3M Company's 3M447 adhesive sheets. Non adhesive cover sheets may also be utilized if a lower level of protection is required or a particularly contamination free manufacturing environment is available.

The contact adhesive must also have various properties. Initially, it must be such that it will capture and retain particulate matter which impacts on its surface. Furthermore, it must be capable of being spread over the cover sheet material in a reasonably even fashion. The contact adhesive must also be such that it will retain its properties over long periods of storage and transportation. The adhesive also must not have an adverse effect on the inspection process, therefore it must not reflect or interfere with the electromagnetic radiation used for inspection nor can it be degraded by exposure to such radiation. It is extremely important that the adhesive be selected such that no conditions which would ordinarily occur during the life of the protected pellicle will cause the adhesive to lose its adhesive properties or to dry up, flake or otherwise become a contaminant in itself.

Desirable adhesives are those which are already present on the preferred cover sheet materials described above. One further possibility is black vinyl adhesive applied to an appropriate cover sheet material.

One successful method of manufacturing and maintaining protective cover sheets prior to installation upon support rings is to utilize a peel-away cover on the sheet itself. The adhesive surface is thus prevented from contamination during storage and the adhesive surface is only exposed at the time of installation. A freshly peeled adhesive surface is virtually certain to be contamination-free and thus will provide no intrinsic contamination. Another possible method is to manufacture the cover sheets such that the interior surfaces of two sheets are juxtaposed and they may be peeled apart to reveal two uncontaminated adhesive surfaces.

Since the interior surface of the preferred cover sheet includes a layer of contact adhesive, as does the support ring, it is a simple matter to install the cover sheet to the spacer ring and then onto the support ring of a pellicle simply by contact. It is desirable that this procedure, and all other in process, be undertaken in conditions which are as free from particulate contamination as possible. This minimizes the chance of contamination passing from other elements of the protected pellicles to the film. The presently preferred timing of the application of the protective cover to the support ring is the manufacturing process of the pellicle, prior to the bonding of the transparent film to the support ring. With the adhesive cover already in position prior to bonding of the film, a sealed clean volume is created immediately upon film bonding. Since, prior bonding, the film presents a planar surface appropriate for various types of cleaning, it may be cleaned and then bonded to the ring in a pristine state. The already installed adhesive cover thus prevents contamination subsequent to installation.

The cover sheet may be precut to shape or trimmed to fit the circumference of the support ring after it has been installed. The precise trimming is optional and not a necessary part of the invention. However, for shipping purposes and appearance it is desirable to maintain as much symmetry as possible. It is desirable to leave a grasping extension at one or more points around the circumference of the cover such that, when the time comes to remove the protective cover and install the pellicle on the photomask, the cover may be easily peeled back.

## Industrial Applicability

The method of producing dustless protected pellicles of the present invention, and the pellicles produced thereby, have immediate and widespread industrial applicability. Since their introduction in the late nineteen-seventies pellicles have become a very valuable tool utilized in the integrated circuit and semiconductor manufacturing industry. It is expected that photomasks utilized without pellicles will become increasingly rare.

In light of the increasing precision required in the industry it is expected that pellicles, and particularly totally uncontaminated protected pellicles, will have widespread marketability. Accordingly, the superior characteristics of pellicles constructed and packaged according to the method of the present invention should result in significant industrial utilization of the invention.

## Claims

1. A method of manufacture of a contamination-protected pellicle including a closed loop support member (16) defining an aperture, characterised by the steps of selecting a planar cover sheet (12), applying a layer of contact adhesive (20) to one surface of the cover sheet (12), and detachably installing the cover sheet (12) upon an axial edge of the support member (16) of a pellicle (10) so as to close the aperture and form, with the pellicle (10), an enclosed volume (19), the orientation of the cover sheet (12) being such that the layer of contact adhesive (20) is within said volume (19).

2. A method of manufacture of a contamination-protected pellicle, comprising a pellicle film (18) to be mounted upon a closed loop support member (16), characterised by the steps of selecting a planar cover sheet (12), applying a layer of contact adhesive (20) to one surface of the cover sheet (12), detachably installing the cover sheet upon an axial end face of the support member (16), and thereafter installing the pellicle film (18) upon the opposite axial end face of the support member (16) to form an enclosed volume (19) within which the layer of contact adhesive (20) is provided.

3. A method according Claim 1 or to Claim 2 characterised by the step of trimming the cover sheet (12) such that its lateral dimensions conform to the exterior circumference of the support member (16).

4. A method according to any preceding claim characterised in that said contact adhesive (20) is selected to capture and retain as much as possible of the particulate matter coming into contact therewith.

5. A method according to any preceding claim characterised in that the step of installing the cover sheet includes stretching the cover sheet (12) such that it is uniformly planar across the interior of the aperture formed by the support member (16).

6. A pellicle in which the interior film surface is protected from particulate contamination, comprising a closed loop support member (16) and a planar transparent film (18) stretched across said support member (16) and bonded thereto along one axial face thereof, characterised by a cover sheet (12), detachably bonded to the other axial face of said support member (16) so as to form a sealed interior volume (19) therewith, the interior facing surface of the cover sheet (12) being provided with a layer of contact adhesive (20).

7. A method or pellicle according to any preceding claim characterised in that the cover sheet (12) is selected such that it does not interfere with electromagnetic radiation inspection processes performed on the pellicle film (18) during the period while the cover sheet (12) is in position.

8. A method or pellicle according to any preceding claim characterised in that the cover sheet (12) and adhesive (20) are selected to be nonreflecting.

9. A method or pellicle according to any preceding claim characterised in that said contact adhesive (20) is selected to retain its adhesive properties over extended time periods and despite exposure to the electromagnetic radiation utilized during pellicle film inspection.

10. A method or pellicle according to any preceding claim characterised in that said contact adhesive (20) is selected to retain complete positional integrity such that it does not fragment or migrate subsequent to application.

11. A method or pellicle according to any preceding claim characterised by a grasping extension (26) provided along a portion of the circumference of the cover sheet (12) such that it may be readily peeled off from the support member (16).

## Patentansprüche

1. Verfahren zur Herstellung einer verschmutzungsgeschützten Filmabdeckung, welche einen umfanggeschlossenen Stützteil (16) umfaßt, der eine Öffnung definiert, dadurch gekennzeichnet, daß eine ebene Überzugsfolie (12) ausgewählt wird, daß eine Schicht Kontaktkleber (20) auf eine Oberfläche der Überzugsfolie (12) aufgebracht wird und daß die Überzugsfolie (12) entfernbar an einem axialen Rand des Stützteiles (16) einer Filmabdeckung (14) aufgebracht wird, um die Öffnung abzuschließen und zusammen mit der Filmabdeckung (14) ein eingeschlossenes Volumen (19) zu bilden, wobei die Ausrichtung der Überzugsfolie (12) derart ist, daß sich die Schicht des Kontaktklebers (20) innerhalb des Volumens (19) befindet.

2. Verfahren zur Herstellung einer verschmutzungsgeschützten Filmabdeckung, die einen Abdeckfilm (18) umfaßt, welcher zur Montage auf einem umfanggeschlossenen Stützteil (16) bestimmt ist, dadurch gekennzeichnet, daß eine ebene Überzugsfolie ausgewählt wird, daß eine Schicht Kontaktkleber (20) auf eine Oberfläche der Überzugsfolie (12) aufgebracht wird und daß die Überzugsfolie entfernbar auf eine axiale Endfläche des Stützteiles (16) aufgebracht wird und danach der Abdeckteil (18) auf die entgegengesetzte axiale Endfläche des Stützteiles (16) aufgebracht wird, um ein eingeschlossenes Volumen (19) zu bilden, innerhalb dessen sich die Schicht des Kontaktklebers (20) befindet.

3. Verfahren nach Anspruch 1 oder 2, dadurch gekennzeichnet, daß die Überzugsfolie (12) so zugeschnitten wird, daß ihre seitliche Ausdehnung dem äußeren Umfang des Stützteiles (16) entspricht.

4. Verfahren nach einem der vorhergehenden Ansprüche, dadurch gekennzeichnet, daß der Kontaktkleber (20) derart ausgewählt wird, daß er so viel wie möglich an kleinen Teilchen (1) fängt und festhält, welche mit ihm in Kontakt kommen.

5. Verfahren nach einem der vorhergehenden Ansprüche, dadurch gekennzeichnet, daß die Aufbringung der Überzugsfolie ein Spannen der Überzugsfolie (12) umfaßt, sodaß sie gleichförmig eben ist über dem Inneren der Öffnung, die durch den Stützteil (16) gebildet ist.

6. Eine Filmabdeckung, in welch die innere Filmoberfläche gegen Verschmutzung durch Teilchen geschützt ist und welche einen Stützteil (16) in Form eines geschlossenen Ringes sowie einen ebenen transparenten Film (18), der über den Stützteil (16) gespannt ist und entlang einer axialen Endfläche damit verbunden ist, umfaßt, dadurch gekennzeichnet, daß eine Überzugsfolie (12) vorgesehen ist, welche abnehmbar verbunden ist mit der anderen axialen Endfläche des Stützteiles (16), sodaß sie damit einen Innenraum (19) bildet, wobei die Fläche der Überzugsfolie (12), welche nach innen weist, mit einer Schicht von Kontaktkleber (20) versehen ist.

7. Verfahren oder Filmabdeckung nach einem der vorhergehenden Ansprüche, dadurch gekennzeichnet, daß die Überzugsfolie (12) derart ausgewählt ist, daß sie mit elektromagnetischer Strahlung ausgeführte Inspektionsprozesse nicht behindert, welche am Abdeckfilm (18) ausgeführt werden, während sich die Überzugsfolie (12) in ihrer Position befindet.

8. Verfahren oder Filmabdeckung nach einem der vorhergehenden Ansprüche, dadurch gekennzeichnet, daß die Überzugsfolie (12) und der Kleber (20) so ausgewählt sind, daß sie nicht reflektieren.

9. Verfahren oder Filmabdeckung nach einem der vorhergehenden Ansprüche, dadurch gekennzeichnet, daß der Kontaktkleber (20) so ausgewählt ist, daß er seine Klebeeigenschaften über längere Zeiträume behält, auch wenn zur Untersuchung des Abdeckfilms elektromagnetische Strahlung verwendet wird.

10. Verfahren oder Filmabdeckung nach einem der vorhergehenden Ansprüche, dadurch gekennzeichnet, daß der Kontaktkleber (20) so ausgewählt ist, daß er in seiner Lage völlig unverändert bleibt und sich nach der Aufbringung weder zerteilt noch wandert.

11. Verfahren oder Filmabdeckung nach einem der vorhergehenden Ansprüche, dadurch gekennzeichnet, daß ein Kreisfortsatz (26) entlang eines Teiles des Umfanges der Überzugsfolie (12) vorgesehen ist, sodaß diese leicht vom Stützteil (16) abgezogen werden kann.

**Revendications**

1. Procédé de fabrication d'une pellicule protégée contre la contamination comprenant un organe porteur (16) en boucle fermée définissant une ouverture, caractérisé par les étapes suivantes: choisir une feuille plane (12) de couverture, appliquer une couche d'un adhésif de contact (20) sur une surface de la feuille de couverture (12) et installer de façon détachable la feuille de couverture (12) sur un bord axial de l'organe porteur (16) d'une pellicule (10) de façon à fermer l'ouverture et à former, avec la pellicule (10), un volume clos (19), l'orientation de la feuille de couverture (12) étant telle que la couche de l'adhésif de contact (20) est à l'intérieur de ce volume (19).

2. Procédé de fabrication d'une pellicule protégée contre la contamination comprenant un film (18) pour composer une pellicule destiné à être monté sur un organe porteur (16) en boucle fermée, caractérisé par les étapes suivantes: choisir une feuille plane (12) de couverture, appliquer une couche d'un adhésif de contact (20) sur une surface de la feuille de couverture (12), installer de façon détachable la feuille de couverture sur une face extrême en sens axial de l'organe porteur (16), et, ensuite, installer le film (18) pour composer la pellicule sur la face d'extrémité opposée en sens axial de l'organe porteur (16) pour former un volume clos (15) à l'intérieur duquel la couche d'adhésif de contact (20) est disposée.

3. Procédé selon la revendication 1 ou la revendication 2, caractérisé par l'opération consistant à découper la feuille de couverture (12) de façon que ses dimensions en sens latéral se conforment à la circonférence extérieure de l'organe porteur (16).

4. Procédé selon l'une quelconque des revendications précédentes, caractérisé en ce que l'adhésif de contact (20) est choisi pour capter et retenir le maximum possible de matières particulaires venant à son contact.

5. Procédé selon l'une quelconque des revendications précédentes, caractérisé en ce que l'opération d'installer la feuille de couverture comprend celle de tendre la feuille de couverture (12) de façon telle qu'elle soit uniformément plane en travers de l'ouverture formée par l'organe porteur (16).

6. Pellicule dans laquelle la surface intérieure du film est protégée de la contamination par des particules, comprenant un organe porteur (16) en boucle fermée et un film (18) plan transparent tendu en travers de cet organe porteur (16) et fixé à celui-ci le long d'une face axiale de ce même organe, caractérisée par une feuille de couverture (12) fixée de façon détachable à l'autre face axiale de l'organe porteur (16) de façon à former avec ce dernier un volume intérieur scellé (19), la surface tournée vers l'intérieur de la feuille de couverture (12) étant revêtue d'une couche d'un adhésif de contact (20).

7. Procédé ou pellicule selon l'une quelconque des revendications précédentes, caractérisé en ce que la feuille de couverture (12) est choisie de telle sorte qu'elle n'interfère pas avec les processus d'inspection à rayonnement électromagnétique exécutés sur le film (18) composant la pellicule pendant la période au cours de laquelle la feuille de couverture (12) est en position.

8. Procédé ou pellicule selon l'une quelconque des revendications précédentes, caractérisé en ce que la feuille de couverture (12) et l'adhésif (20) sont choisis pour être non réfléchissants.

9. Procédé ou pellicule selon l'une quelconque des revendications précédentes, caractérisé en ce que l'adhésif de contact (20) est choisi pour conserver ses propriétés adhésives pendant des périodes de temps étendues et en dépit de l'exposition au rayonnement électromagnétique utilisé pendant l'inspection du film composant la pellicule.

10. Procédé ou pellicule selon l'une quelconque des revendications précédentes, caractérisé en ce que l'adhésif de contact (20) est choisi pour conserver complètement son intégrité à sa position de façon telle qu'il ne se fragmente pas ou ne migre pas après son application.

11. Procédé ou pellicule selon l'une des revendications précédentes, caractérisé par un prolongement (26) de préhension, prévu le long d'une partie de la circonférence de la feuille de couverture (12) de sorte que celle-ci peut être retirée facilement par pelage de l'organe porteur (16).

FIG. 1

FIG. 2

1